# EUROPEAN PATENT APPLICATION

(11) **EP 2 487 730 A2**
(43) Date of publication of application: **15.08.2012**
(21) Application number: 12153743.5
(22) Date of filing: 03.02.2012
(51) Int. Cl.: H01L 33/48, H01L 33/36, H01L 33/62

(54) **Flip chip LED package and manufacturing method thereof**

(30) Priority: 10.02.2011 KR 20110011877
(71) Applicant: Samsung LED Co., Ltd., Yongi-city, Gyeonggi-Do 446-711 (KR)
(72) Inventor: Kim, Kwon Joong, 447-310 Gyeonggi-do (KR); Paek, Ho Sun, 443-370 Gyeonggi-do (KR); Kim, Hak Hwan, 443-706 Gyeonggi-do (KR)
(74) Representative: Grünecker, Kinkeldey, Stockmair & Schwanhäusser

(57) **Abstract**

A flip chip LED package (100) and a manufacturing method thereof are provided. The flip chip LED package (100) includes a package substrate (110) including a cavity (111) that exposes a circuit pattern (114,115), and a chip mounting portion (113) disposed on a bottom surface (112) of the cavity (111); a solder layer (120a,120b) disposed on the circuit pattern (114,115); a bonding tape layer (130) disposed on the chip mounting portion (113); and an LED chip (140) including a bonding object region (A) and a plurality of electrode pads (141,142) disposed on one surface, being mounted on the package substrate (110) such that the plurality of electrode pads (141,142) are bonded to the solder layer (120a,120b) and the bonding object region (A) is bonded to the bonding tape layer (130).

## Description

### CROSS-REFERENCE TO RELATED APPLICATION

This application claims the benefit of Korean Patent Application No. 10-2010-0011877, filed on February 10, 2011, in the Korean Intellectual Property Office, the disclosure of which is incorporated herein by reference.

### BACKGROUND

### 1. Field of the Invention

The present invention relates to a flip chip light emitting device (LED) package and a manufacturing method thereof, and more particularly, to a flip chip LED package and a manufacturing method thereof capable of simplifying the manufacturing process and increasing reliability.

### 2. Description of the Related Art

A light emitting device (LED) refers to a semiconductor device capable of emitting light in various colors through a light source by varying materials of a compound semiconductor, such as GaAs, AlGaAs, GaN, InGaInP, and the like. In general, the LED is manufactured in a package form.

Recently, the LED package being developed and manufactured is in a flip chip structure. The flip chip LED package may be manufactured by forming a solder bump on an electrode pad provided in an LED, performing a reflow process, and flip-chip bonding the LED to a package substrate.

After the reflow process, a process for removing residual flux remaining on the solder bump needs to be additionally performed. In addition, after the LED is flip-chip bonded to the package substrate, an underfill process needs to follow to increase adhesion of the solder bump. The flux removal process and the underfill process may increase the processing cost and time.

When the underfill process is performed, an underfill material surrounds a lateral surface of the LED, thereby causing loss of light through the lateral surface. Moreover, the LED may be displaced while the LED is flip-chip bonded to the package substrate after the reflow process. In this case, reliability may be reduced.

### SUMMARY

An aspect of the present invention provides a flip chip light emitting device (LED) package and a manufacturing method thereof, capable of reducing processing cost and time by forming a solder paste and a bonding tape layer directly on a package substrate, mounting an LED, and performing a reflow process.

According to an aspect of the present invention, there is provided a flip chip light emitting device (LED) package including a package substrate comprising a cavity that exposes a circuit pattern, and a chip mounting portion disposed on a bottom surface of the cavity; a solder layer disposed on the circuit pattern; a bonding tape layer disposed on the chip mounting portion; and an LED comprising a bonding object region and a plurality of electrode pads disposed on one surface, being mounted on the package substrate such that the plurality of electrode pads are bonded to the solder layer and the bonding object region is bonded to the bonding tape layer.

The chip mounting portion may have a step shape on a bottom surface of the cavity.

The bonding tape layer may have height which is greater than height of the solder layer disposed on the circuit pattern.

The bonding tape layer disposed on the chip mounting portion may include an epoxy-based resin and a curing agent.

The flip chip LED package may further include a phosphor layer coating a light emission layer of the LED; and a molding unit filling an inside of the cavity including the phosphor layer.

The plurality of electrode pads may be disposed on both sides of the chip mounting portion.

According to another aspect of the present invention, there is provided a manufacturing method for a flip chip light emitting device (LED) package, the manufacturing method including cutting an LED wafer comprising a plurality of LEDs disposed on one surface into individual LEDs each comprising a bonding object region and a plurality of electrode pads; preparing a package substrate comprising a cavity that exposes a circuit pattern, and a chip mounting portion disposed on a bottom surface of the cavity; screen-printing a solder paste on the circuit pattern; bonding a bonding tape layer to the chip mounting portion; mounting the cut LEDs on the package substrate such that the plurality of electrode pads face the solder paste and the bonding object region is bonded to the bonding tape layer; and reflowing the package substrate on which the cut LEDs are mounted.

The preparing of the package substrate may be performed such that the chip mounting portion has a step shape on the bottom surface of the cavity.

The bonding of the bonding tape layer to the chip mounting portion may include forming a bonding material containing an epoxy-based resin and a curing agent; forming the bonding tape layer having a size corresponding to the bonding object region by applying the bonding material to a predetermined thickness; and bonding the bonding tape layer to the chip mounting portion.

The forming of the bonding tape layer on the chip mounting portion may be performed such that the bonding tape layer has height which is greater than height of a solder paste disposed on the circuit pattern.

The bonding tape layer may fix the cut LEDs during the reflow of the package substrate on which the cut LEDs are mounted.

The reflowing of the package substrate on which the cut LEDs are mounted may include bonding the plurality of electrode pads to the solder paste by soldering the solder paste by the reflow; and curing the bonding tape layer.

The manufacturing method may further include coating a light emission surface with a phosphor material, the light emission surface including a lateral surface of the LEDs mounted on the package substrate; and filling an inside of the cavity including the LEDs with a transparent resin.

The manufacturing method may further include coating a light emission surface including a lateral surface of the LEDs with a phosphor material before the cut LEDs are mounted to the package substrate.

### BRIEF DESCRIPTION OF THE DRAWINGS

These and/or other aspects, features, and advantages of the invention will become apparent and more readily appreciated from the following description of exemplary embodiments, taken in conjunction with the accompanying drawings of which:
FIG. 1 is a plan view showing a structure of a flip chip light emitting device (LED) package according to an embodiment of the present invention;
FIG. 2 is a sectional view of the flip chip LED package shown in FIG. 1, cut along a line I-I';
FIGS. 3 through 10 are diagrams describing a method of manufacturing the flip chip LED package according to an embodiment of the present invention; and
FIG. 11 is a sectional view of a flip chip LED package according to another embodiment of the present invention.

### DETAILED DESCRIPTION

Reference will now be made in detail to exemplary embodiments of the present invention, examples of which are illustrated in the accompanying drawings, wherein like reference numerals refer to the like elements throughout. The terminology used herein is for the purpose of describing particular embodiments only and is not intended to be limiting of the invention. Therefore, definitions of the terms are to be interpreted as the same meaning as described throughout the specification.

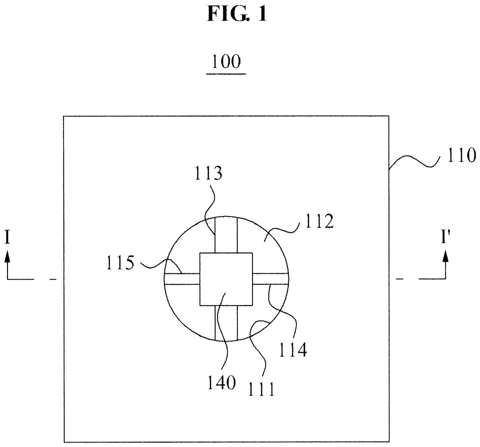

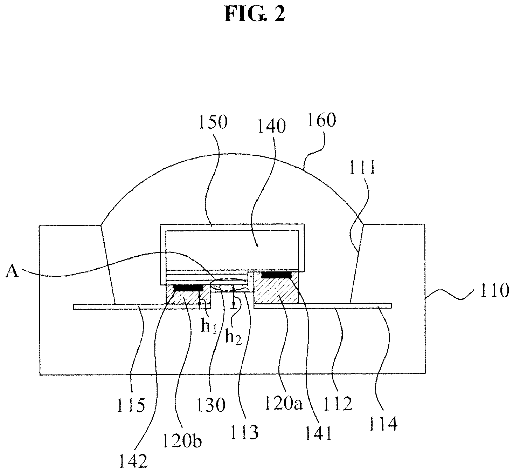

FIG. 1 is a plan view showing a structure of a flip chip light emitting device (LED) package 100 according to an embodiment of the present invention. FIG. 2 is a sectional view of the flip chip LED package 100 shown in FIG. 1, cut along a line I-I`. The flip chip LED package according to the embodiment will be described in detail with reference to FIGS. 1 and 2.

Referring to FIG. 2, the flip chip LED package 100 may include a package substrate 110, solder layers 120a and 120b, a bonding tape layer 130, an LED 140, a phosphor layer 150, and a molding unit 160. Although only the package substrate 110 and the LED 140 are shown in FIG. 1, the flip chip LED package 100 may further include the phosphor layer 150 and the LED 160.

The package substrate 110 may include a cavity 111 through which circuit patterns 114 and 115 are exposed. The circuit patterns 114 and 115 may correspond to a plurality of electrode pads, for example, electrode pads 141 and 142 included in the LED 140.

The package substrate 110 may also include a chip mounting portion 113 formed in a step shape on a bottom surface 112 of the cavity 111.

The solder layers 120a and 120b are disposed on the circuit patterns 114 and 115 exposed through the cavity 111. The solder layers 120a and 120b bond the LED 140 and electrically connect the LED 140 with an external circuit. The solder layers 120a and 120b may have a first height h₁. Although the solder layers 120a and 120b disposed on both sides of the chip mounting portion 113 have different heights in the drawing, the drawing shows a result of a reflow process that changes the heights by melting the solder layers 120a and 120b. Therefore, only one of the solder layers 120a and 120b has the first height h₁ after the reflow process.

The bonding tape layer 130 may be disposed on the chip mounting portion 113. The bonding tape layer 130 may function as an underfill material to protect the solder layers 120a and 120b and improve adhesion of the LED 140. The bonding tape layer 130 may include a bonding material containing an epoxy-based resin and a curing agent. The bonding tape layer 130 may have a second height h₂ greater than the first height h₁ of the solder layers 120a and 120b disposed on the circuit patterns 114 and 115. More specifically, the bonding tape layer 130 may have the second height h₂ from the bottom surface 112 of the cavity 111 including a height of the chip mounting portion 113. The bonding tape layer 130 physically separates the solder layers 120a and 120b disposed on both sides of the chip mounting portion 113.

The LED 140 may include a bonding object region A and the electrode pads 141 and 142, which are disposed on one surface. The electrode pads 141 and 142 may include a first electrode pad 141 and a second electrode pad 142. The first electrode pad 141 and the second electrode pad 142 may be disposed on both sides of the bonding object region A, respectively. The first electrode pad 141 may be disposed on a region etched into a mesa structure.

Also, the LED 140 may be mounted on the package substrate 110 such that the first electrode pad 141 and the second electrode pad 142 are bonded to the solder layers 120a and 120b disposed on both sides of the chip mounting portion 113 and that the bonding object region A is bonded to the bonding tape layer 130. That is, the LED 140 may be mounted into a flip chip structure on the package substrate 110.

The phosphor layer 150 may coat a light emission surface of the LED 140, the light emission surface which includes a lateral surface of the LED 140. The phosphor layer 150 may include phosphor particles for converting a wavelength of the light emitted from the LED 140.

The molding unit 160 may fill an inside of the cavity 111 including the phosphor layer 150. The molding unit 160 may contain a silicone-based resin or epoxy-based resin having transparency. The molding unit 160 may protect the LED 140 and the phosphor layer 150 from external circumstances. In addition, the molding unit 160 may have a hemispheric shape convex upward for more efficient light extraction.

According to the LED 100 shown in FIG. 1, since the LED 140 is mounted on the package substrate 110 through the bonding tape layer 130, adhesion of the LED 140 is increased. In addition, since the bonding tape layer 130 having an epoxy function is disposed only on the bonding object region A, not on the lateral surface of the LED 140, loss of light through the lateral surface may be prevented.

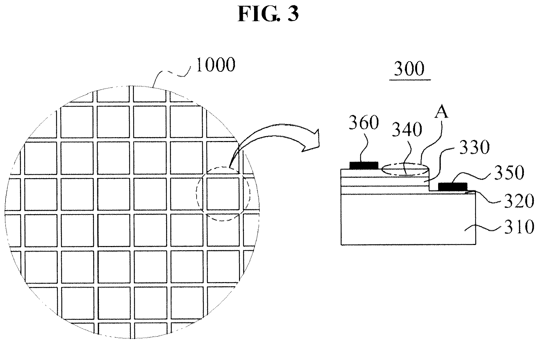

FIGS. 3 through 10 are diagrams describing a manufacturing method of the flip chip LED package according to an embodiment of the present invention.

Referring to FIG. 3, the manufacturing method for the flip chip LED package may include cutting an LED wafer 1000 into individual LEDs. Specifically, the LED wafer 1000 including a plurality of LEDs as shown in FIG. 3 is cut and separated into individual chips.

Since the plurality of LEDs 300 of the LED wafer 1000 all have the same structure, a structure of one of the LEDs 300 will be representatively explained. Referring to an enlarged view of the LED 300 of the LED wafer 1000 in FIG. 3, the LED 300 may include a substrate 310, a first nitride semiconductor layer 320, an active layer 330, a second nitride semiconductor layer 340, a first electrode pad 350, and a second electrode pad 360.

The substrate 310 includes a light emission surface. A transparent substrate such as a sapphire (Al₂O₃) substrate, a SiC substrate, a GaAs substrate, and the like may be applied as the substrate 310.

The first nitride semiconductor layer 320, the active layer 330, and the second nitride layer 340 may be deposited on the substrate 310 in sequence. A mesa-etching structure is formed from the second nitride semiconductor layer 340 up to a part of the first nitride semiconductor layer 320 wherein the part of the first nitride semiconductor layer 320 may be exposed by the mesa-etching structure.

The first electrode pad 350 may be disposed on the first nitride semiconductor layer 320 while the second electrode pad 360 may be disposed on the second nitride semiconductor layer 340. The first electrode pad 350 and the second electrode pad 360 are disposed on one surface of the LED 300. On the one surface of the LED 300, a space between the first electrode pad 350 and the second electrode pad 360 may be designated as the bonding object region A.

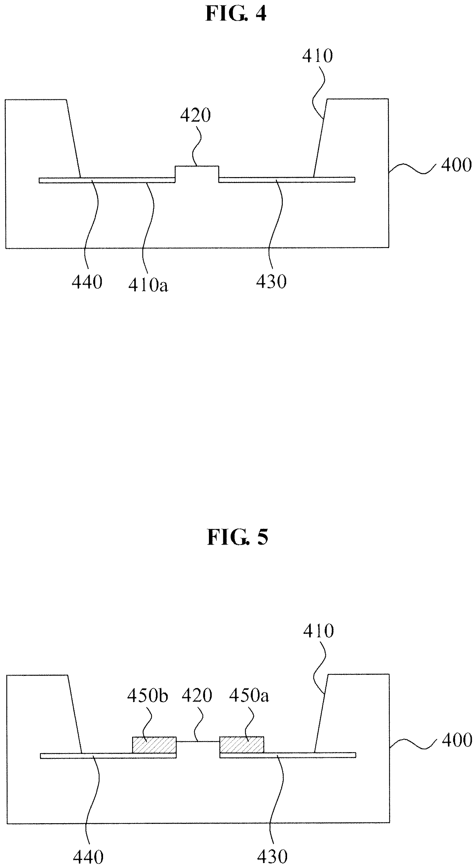

Referring to FIG. 4, the manufacturing method of the flip chip LED package may include preparing a package substrate 400. The package substrate 400 may include a cavity 410 exposing circuit patterns 430 and 440, and a chip mounting portion 420 formed in a step shape on a bottom surface 410a of the cavity 410.

The package substrate 410 may be formed by injection molding. For example, in a state where the circuit patterns 430 and 440 are disposed in a mold (not shown) for forming the package substrate 400, a molding material (insulating material) may be injected into the mold, cured, and then removed, thereby forming the package substrate 410. Here, the mold may include a structure for forming the chip mounting portion 420. That is, the mold may include a depression corresponding to the cavity 410 in shape, and the depression may include a convex space such that the molding material is injected into the convex space. Accordingly, the chip mounting portion 420 is formed.

The chip mounting portion 420 may be formed on the bottom surface 410a of the cavity 410 in the step shape. Accordingly, the chip mounting portion 420 may have the first height h₁ from the bottom surface 410a of the cavity 410.

Referring to FIG. 5, the manufacturing method of the flip chip LED package may include screen-printing solder pastes 450a and 450b on the circuit pattern 430 and 440. Specifically, the solder pastes 450a and 450b are manufactured by at least one metal material selected from tin (Sn), silver (Ag), zinc (Zn), and bismuth (Bi). A mask (not shown) having a hole pattern corresponding to a part of the circuit patterns 430 and 440 is disposed on the package substrate 410. Here, the hole pattern may expose only partial regions of the circuit patterns 430 and 440, the regions corresponding to the electrode pads 350 and 360 of the LED 300. Next, the solder pastes 450a and 450b are screen-printed in the hole pattern, and the mask is removed from the package substrate 410. Accordingly, the solder pastes 450a and 450b may be formed in regions corresponding to the electrode pads 350 and 360 of the LED 300.

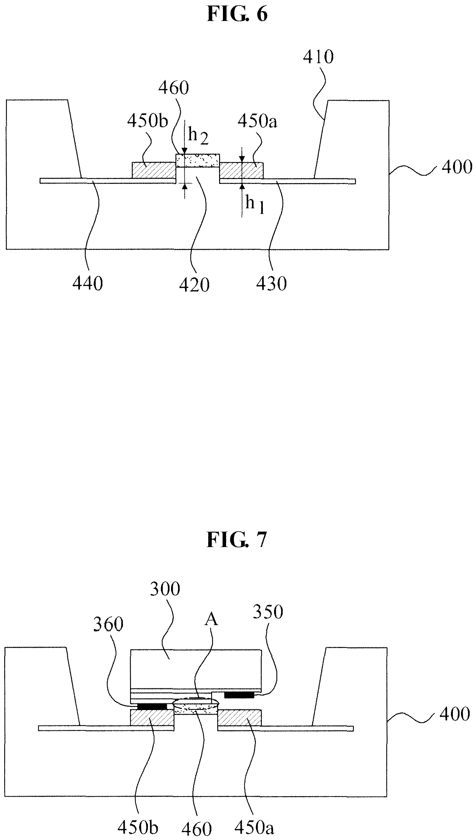

Referring to FIG. 6, the manufacturing method of the flip chip LED package may include bonding a bonding tape layer 460 to the chip mounting portion 420. The bonding tape layer 460 may include a bonding material containing an epoxy-based resin and a curing agent. For example, the bonding tape layer 460 may be manufactured by applying the bonding material to a predetermined thickness on a dedicated sheet, drying the bonding material, and bonding the dried bonding material to the chip mounting portion 420. Alternatively, the bonding tape layer 460 may be directly applied to the chip mounting portion 420.

The bonding tape layer 460 may have a second height h₂ which is greater than the first height h₁ of the solder pastes 450a and 450b formed on the circuit patterns 430 and 440. The bonding tape layer 460 may have the second height h₂ from the bottom surface 410a of the cavity 410 including a height of the chip mounting portion 420. The bonding tape layer 460 physically separates the solder pastes 450a and 450b disposed on both sides of the chip mounting portion 420.

Referring to FIG. 7, the manufacturing method of the flip chip LED package may include mounting the LED 300 on the package substrate 400. When the LED wafer 1000 (FIG. 3) is cut in units of LEDs and separated into individual chips, that is, the LEDs 300 as shown in FIG. 3, the LEDs 300 are mounted on the package substrate 400, thereby manufacturing the flip chip LED package.

Here, the LEDs 300 are mounted on the package substrate 400 in the flip chip structure where the first electrode pad 350 and the second electrode pad 360 face the solder pastes 450a and 450b, respectively, and the bonding object region A is bonded to the bonding tape layer 460.

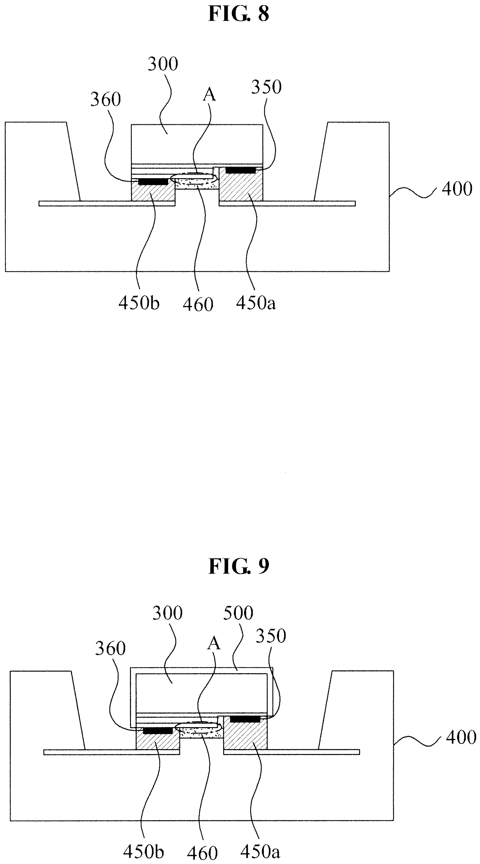

Referring to FIG. 8, the manufacturing method of the flip chip LED package may include reflowing the package substrate 400 on which the LEDs 300 are mounted. During the reflow process, the solder pastes 450a and 450b are soldered so that the first electrode pad 350 and the second electrode pad 360 are bonded to the solder pastes 450a and 450b. In addition, the bonding tape layer 460 may be cured in the reflow process. A soldering process and an underfill process may be simultaneously performed during the reflow process. That is, the soldering process and the underfill process may be simplified.

The bonding tape layer 460 formed on the chip mounting portion 420 may fix the LEDs 300 mounted on the package substrate 400 during the reflow process, so that the package substrate 400 is not displaced. Consequently, decrease in reliability caused by displacement of the package substrate 400 may be prevented.

Since the solder pastes 450a and 450b are directly formed on the package substrate 400 and then the LEDs 300 are mounted and reflowed, a process for removing residual flux remaining on the solder pastes 450a and 450b is not necessary. Thus, the flux removal process is omitted, thereby reducing the processing time and cost.

In addition, although the solder pastes 450a and 450b melt and flow during the reflow process, the solder pastes 450a and 450b being physically separated by the bonding tape layer 460 may be prevented from being joined together. Accordingly, decrease in reliability of caused by joining of the solder pastes 450a and 450b at the bonding object region A may be reduced.

Referring to FIG. 9, the manufacturing method of the flip chip LED package may include coating a light emission surface including a lateral surface of the LEDs 300 with a phosphor material 500. The phosphor material 500 may include phosphor particles for converting a wavelength of the light emitted from the LEDs 300. Type of the phosphor particles may be varied according to the wavelength of the light emitted from the LEDs 300 and a color of the light to be realized through the flip chip LED package.

According to the description with respect to FIG. 9, the phosphor material 500 coats the LEDs 300 being mounted on the package substrate 400. However, the phosphor material 500 may be applied before the LEDs 300 are mounted on the package substrate 400. Specifically, before the LEDs 300 are mounted on the package substrate 400, the light emission surface including the lateral surface of the LEDs 300 may be coated with the phosphor material 500 and the LEDs 300 coated with the phosphor material 500 may be mounted on the package substrate 400.

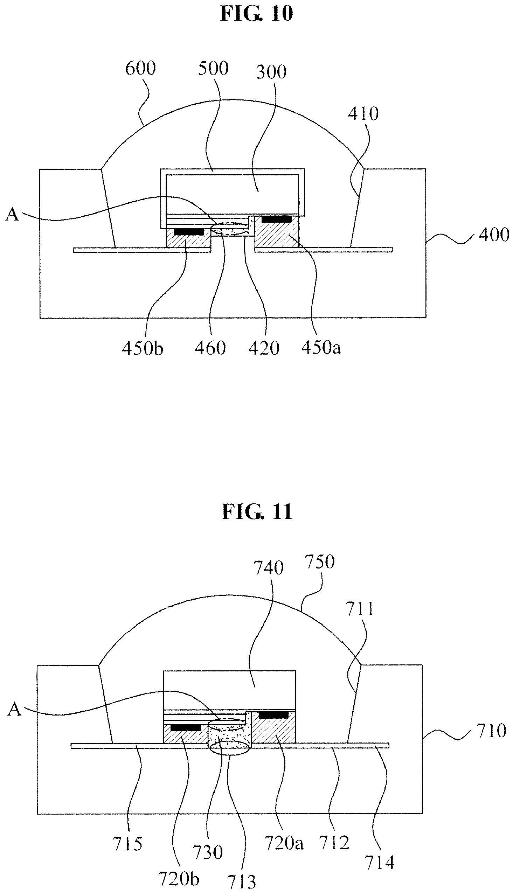

Referring to FIG. 10, the manufacturing method of the flip chip LED package may include filling an inside of the cavity 410 including the LEDs 300 with a transparent resin 600. The transparent resin 600 may be an epoxy-based resin or silicone-based resin. The transparent resin 600 may be formed on the cavity 410 into a hemispheric shape with an upward convexity, thereby increasing the light extraction efficiency.

FIG. 11 is a sectional view of a flip chip LED package according to another embodiment of the present invention. Referring to FIG. 11, the flip chip LED package may include a package substrate 710, solder layers 720a and 720b, a bonding tape layer 710, an LED 740, and a molding unit 750.

The package substrate 710 includes a cavity 711, and circuit patterns 714 and 715 exposed through a bottom surface 712 of the cavity 711. The circuit patterns 714 and 715 may correspond to a plurality of electrode pads included in the LED 740.

The package substrate 710 may also include a chip mounting portion 713 formed on the bottom surface 712 of the cavity 711. The chip mounting portion 713 may correspond to a bonding object region A included in the LED 740 when the LED 740 is mounted. In a manner distinct from the chip mounting portion 113 shown in FIG. 2, the chip mounting portion 713 may not have a step shape with respect to the bottom surface 712 of the cavity 711.

According to other embodiments, the chip mounting portion may be depressed to a predetermined depth from the bottom surface 712 of the cavity 711. Alternatively, the chip mounting portion may protrude by a predetermined height on a region contacting the circuit patterns 720a and 720b. Also, an insulating material may coat the chip mounting portion to a predetermined thickness. The forgoing example structures of the chip mounting portion may be used as a barrier layer between the solder layers 720a and 720b to prevent joining of the solder layers 720a and 720b to each other during a reflow process.

The solder layers 720a and 720b may be disposed on the circuit patterns 714 and 715 exposed through the cavity 711. The solder layers 720a and 720b may bond the LED 740 and electrically connect the LED 740 with an external circuit.

The bonding tape 730 may be disposed on the chip mounting portion 713. The bonding tape layer 730 may function as an underfill material to protect the solder layers 720a and 720b and improve adhesion of the LED 740. The bonding tape layer 730 may have a greater height than the solder layers 720a and 720b and physically separate the solder layers 720a and 720b disposed on both sides of the chip mounting portion 713.

The LED 740 may include the bonding object region A and the plurality of distortion pads. The LED 740 is mounted on the package substrate 710 such that the plurality of electrode pads are bonded to the solder layers 720a and 720b disposed on both sides of the chip mounting portion 713 and that the bonding object region A is bonded to the bonding tape layer 730. That is, the LED 740 is mounted into a flip chip structure on the package substrate 710.

The molding unit 750 may fill an inside of the cavity 711 including the LED 740. The molding unit 750 may contain a silicone-based resin or epoxy-based resin having transparency. The molding unit 750 may protect the LED 740 from external circumstances.

In addition, the molding unit 750 may include phosphor particles for converting a wavelength of light emitted from the LED 740. In a manner distinct from the structure shown in FIG. 2 where the phosphor layer 150 coats the light emission surface of the LED 140, the molding unit 750 may have the wavelength conversion function by including the phosphor particles.

Although a few exemplary embodiments of the present invention have been shown and described, the present invention is not limited to the described exemplary embodiments. Instead, it would be appreciated by those skilled in the art that changes may be made to these exemplary embodiments without departing from the principles and spirit of the invention, the scope of which is defined by the claims and their equivalents.

## Claims

1. A flip chip light emitting device (LED) package comprising:
a package substrate comprising a cavity that exposes a circuit pattern, and a chip mounting portion disposed on a bottom surface of the cavity;
a solder layer disposed on the circuit pattern;
a bonding tape layer disposed on the chip mounting portion; and
an LED comprising a bonding object region and a plurality of electrode pads disposed on one surface, being mounted on the package substrate such that the plurality of electrode pads are bonded to the solder layer and the bonding object region is bonded to the bonding tape layer.

2. The flip chip LED package of claim 1, wherein the chip mounting portion has a step shape on a bottom surface of the cavity.

3. The flip chip LED package of claim 1, wherein the bonding tape layer has height which is greater than height of the solder layer disposed on the circuit pattern.

4. The flip chip LED package of claim 1, wherein the bonding tape layer disposed on the chip mounting portion comprises an epoxy-based resin and a curing agent.

5. The flip chip LED package of claim 1, further comprising:
a phosphor layer coating a light emission layer of the LED; and
a molding unit filling an inside of the cavity including the phosphor layer.

6. The flip chip LED package of claim 1, wherein the plurality of electrode pads are disposed on both sides of the chip mounting portion.

7. A manufacturing method for a flip chip light emitting device (LED) package, the manufacturing method comprising:
cutting an LED wafer comprising a plurality of LEDs disposed on one surface into individual LEDs each comprising a bonding object region and a plurality of electrode pads;
preparing a package substrate comprising a cavity that exposes a circuit pattern, and a chip mounting portion disposed on a bottom surface of the cavity;
screen-printing a solder paste on the circuit pattern;
bonding a bonding tape layer to the chip mounting portion;
mounting the cut LEDs on the package substrate such that the plurality of electrode pads face the solder paste and the bonding object region is bonded to the bonding tape layer; and
reflowing the package substrate on which the cut LEDs are mounted.

8. The manufacturing method of claim 7, wherein the preparing of the package substrate is performed such that the chip mounting portion has a step shape on the bottom surface of the cavity.

9. The manufacturing method of claim 7, wherein the bonding of the bonding tape layer to the chip mounting portion comprises:
forming a bonding material containing an epoxy-based resin and a curing agent;
forming the bonding tape layer having a size corresponding to the bonding object region by applying the bonding material to a predetermined thickness; and
bonding the bonding tape layer to the chip mounting portion.

10. The manufacturing method of claim 7, wherein the forming of the bonding tape layer on the chip mounting portion is performed such that the bonding tape layer has height which is greater than height of a solder paste disposed on the circuit pattern.

11. The manufacturing method of claim 7, wherein the bonding tape layer fixes the cut LEDs during the reflow of the package substrate on which the cut LEDs are mounted.

12. The manufacturing method of claim 7, wherein the reflowing of the package substrate on which the cut LEDs are mounted comprises:
bonding the plurality of electrode pads to the solder paste by soldering the solder paste by the reflow; and
curing the bonding tape layer.

13. The manufacturing method of claim 7, further comprising:
coating a light emission surface with a phosphor material, the light emission surface including a lateral surface of the LEDs mounted on the package substrate; and
filling an inside of the cavity including the LEDs with a transparent resin.

14. The manufacturing method of claim 7, further comprising coating a light emission surface including a lateral surface of the LEDs with a phosphor material before the cut LEDs are mounted to the package substrate.
